# EUROPEAN PATENT APPLICATION

(11) **EP 4 521 882 A1**
(43) Date of publication of application: **12.03.2025**
(21) Application number: 24198190.1
(22) Date of filing: 03.09.2024
(51) Int. Cl.: H10D 30/01, H10D 30/66, H10D 62/10, H10D 62/13, H10D 62/17

(54) **POWER SEMICONDUCTOR DEVICE AND POWER CONVERTER INCLUDING THE SAME**

(30) Priority: 08.09.2023 KR 20230119646
(71) Applicant: LX Semicon Co., Ltd., Daejeon 34027 (KR)
(72) Inventor: LEE, Ho Jung, 34027 Daejeon (KR); KIM, Jin Gon, 34027 Daejeon (KR); LEE, Chae Deok, 34027 Daejeon (KR); LEE, Chung Kwang, 34027 Daejeon (KR)
(74) Representative: Ter Meer Steinmeister & Partner

(57) **Abstract**

A power semiconductor device may include a substrate, a first epi layer of first conductivity type disposed on the substrate, a second epi layer of first conductivity type disposed on the first epi layer of first conductivity type, a first well of second conductivity type disposed on the second epi layer of first conductivity type, a first conductivity type source area disposed on the second conductivity type first well, a gate insulating layer disposed on a bottom and sidewalls of the trench area from which a portion of first conductive type source area, the first well of second conductive type, and the second epi layer of first conductive type are removed, a trench gate disposed in the trench on the gate insulating layer, a second well of second conductivity type disposed on the second epi layer of first conductivity type and spaced apart from the gate insulating layer and an ion implantation connection region of second conductivity type connecting the first well of second conductivity type and the second well of second conductivity type.

## Description

### TECHNICAL FIELD

The embodiment relates to a power semiconductor device, a power semiconductor module, a power converter, and a method of manufacturing the same.

### BACKGROUND

Power semiconductors are one of the key elements that determine the efficiency, speed, durability, and reliability of power electronic systems.

With the recent development of the power electronics industry, the previously used silicon (Si) power semiconductors have reached their physical limits. And to replace silicon power semiconductor, research is being actively conducted on WBG (wide bandgap) power semiconductors such as silicon carbide (SiC) and gallium nitride (GaN).

WBG power semiconductor devices have a band gap energy that is approximately three times that of Si power semiconductor devices. Due to this, WBG power semiconductor device has the characteristics of low intrinsic carrier concentration, high breakdown electric field (about 4 to 20 times), high thermal conductivity (about 3 to 13 times), and large electron saturation rate (about 2 to 2.5 times).

These characteristics enable operation in high temperature and high voltage environments and have high switching speed and low switching loss. Among these, gallium nitride (GaN) power semiconductor devices can be used in low-voltage systems, and silicon carbide (SiC) power semiconductor devices can be suitable for high-voltage systems.

SiC MOSFET power semiconductors of the prior art are generally denoted as VDMOSFET with a vertical diffused structure, and may also be simply denoted as double-diffused structure DMOSFET. Additionally, SiC MOSFET can be classified into Planar MOSFET and Trench MOSFET depending on the direction of the channel.

Among these, Trench MOSFET is a structure in which a channel is formed on the sidewall of the trench. For this, a gate insulating film is formed on the sidewall of the trench and a gate electrode is formed in the trench.

Since SiC MOSFET have high ON-resistance (Rₒₙ) due to low channel mobility and large channel resistance, trench MOSFET were proposed to reduce this. Trench MOSFET has the advantage of increasing channel density by forming channels on the sidewalls of the trench.

However, the trench MOSFET has a larger electric field in the trench gate oxide, which has a shorter drift distance than the P-base (P-well). In particular, since the electric field is concentrated at the trench edge of the trench, there is a problem that gate oxide breakdown occurs quickly and the breakdown voltage (BV) decreases.

For example, in the case of SiC Trench MOSFET, the breakdown field strength is 10 times that of silicon (Si), so SiC semiconductor devices are used with a voltage close to 10 times that of Si devices. For this reason, an electric field 10 times stronger than that of the silicon device is applied to the gate insulating film formed in the trench, causing a problem in which the gate insulating film is easily destroyed at the corners of the trench.

In internal technology, research was conducted to place a bottom P-well under the trench to prevent electric field concentration at the trench corner of the SiC Trench MOSFET.

However, although the bottom P-well to prevent electric field concentration at the corner of the trench contributes to preventing breakdown voltage drop, there is a technical contradiction in that the On-resistance (Rₒₙ) increases due to the bottom P-well.

### SUMMARY

One of the technical objects of the embodiment is to solve the technical contradiction of preventing breakdown voltage drop and increasing on-resistance (Rₒₙ) due to preventing electric field concentration at the corner of the trench.

For example, an embodiment is intended to prevent the On-resistance from increasing while preventing electric field concentration in the bottom P-well at the corner of the trench.

At least one of the technical objects is solved by the features of the independent claim. The technical problems of the embodiments are not limited to those described in this item and include those that can be understood through the description of the invention.

A power semiconductor device according to the embodiment may include a substrate 110, a first epi layer 111 of first conductivity type disposed on the substrate 110, a second epi layer 112 of first conductivity type disposed on the first epi layer 111 of first conductivity type, a first well 121 of second conductivity type disposed on the second epi layer 112 of first conductivity type, a first conductivity type source region 141 disposed on the second conductivity type first well 121, a gate insulating layer 131 disposed on a bottom and sidewalls of the trench region from which a portion of first conductive type source region 141, the first well 121 of second conductive type, and the second epi layer 112 of first conductive type are removed, a trench gate 132 disposed in the trench on the gate insulating layer 131, a second well 124 of second conductivity type disposed on the second epi layer 112 of first conductivity type and spaced apart from the gate insulating layer 131 and a second conductivity type ion implantation connection region 126 connecting the second conductivity type first well 121 and the second conductivity type second well 124.

When a ground potential is applied to the first well 121 of second conductivity type, a ground potential may be applied to the second well 124 of second conductivity type by the ion implantation connection region 126 of second conductivity type.

The second well 124 of second conductivity type may be disposed below the trench and/or may be disposed in a continuous form along the trench area.

The second well 124 of second conductivity type may be arranged to extend horizontally in the first direction Y, e.g. which may be the direction in which the trench gate 132 extends.

The ion implantation connection region 126 of second conductivity type may be arranged to extend in a second direction X perpendicular to the first direction Y, e.g. which may be the direction in which the trench gate 132 extends.

The ion implantation connection region 126 of second conductivity type may be connecting a second well 124 of second conductivity type which is spaced apart in the first direction Y and/or horizontally arranged in the first direction Y and/or disposed to extend in the second direction X perpendicular to the first direction Y.

The top of second conductivity type ion implantation connection region 126 may be disposed higher than the bottom of the gate insulating layer 131, and/or the bottom of second conductivity type ion implantation connection region 126 may be disposed lower than the bottom of the gate insulating layer 131.

The ion implantation connection region 126 of second conductivity type may continuously connect the second wells 124 of second conductivity type of three or more adjacent cells.

The ion implantation connection region of second conductivity type may connect the second well of second conductivity type by crossing on a single cell basis.

The ion implantation connection region of second conductivity type may include a first ion implantation connection region of second conductivity type 126a. The first ion implantation connection region of second conductivity type 126a may connect the second well 124 of second conductivity type disposed below the trench area of first cell area and the second well 124 of second conductivity type disposed below the trench area of a third cell area adjacent to the first cell area in the X axis direction.

The first ion implantation connection region 126a of second conductivity type may connect the second conductivity type of second well 124 of first cell area and the second conductivity type of second well 124 of the third cell area to the second conductivity type of first well 121 disposed on the upper side of first ion implantation connection region 126a of second conductivity type.

The ion implantation connection region of second conductivity type may include a second ion implantation connection region 126b of second conductivity type. The second ion implantation connection region 126b of second conductivity type may connect the second well 124 of second conductivity type located at the bottom of the trench area of second cell area and the second well 124 of second conductivity type located at the bottom of the trench area of an adjacent fourth cell area in the negative (-) direction of the X-axis of second cell area.

The second ion implantation connection region 126b of second conductivity type may connect the second well 124 of second conductivity type of second cell area and the second well 124 of second conductivity type of the fourth cell area to the first well 121 of second conductivity type disposed on the second ion implantation connection region 126b of second conductivity type.

The second well 124 of second conductivity type may include a second-first well 124a of second conductivity type and/or a second-second well 124b of second conductivity type disposed at the corners on both sides of the trench, respectively.

The second well 124 of second conductivity type may include a second-first well 124a of second conductivity type and a second-second well 124b of second conductivity type which are respectively disposed below the corners on both sides of the trench in the extending direction of the trench gate 132.

The ion implantation connection region of second conductivity type may connect the second well of second conductivity type by crossing on a single cell basis.

The ion implantation connection region of second conductivity type may include a first ion implantation connection region 126a of second conductivity type that connects the second-first well 124a of second conductivity type disposed at the bottom of the trench area of first cell area and the second-second well 124b of second conductivity type disposed at the bottom of the trench area of an adjacent third cell area in the positive direction of the X-axis of first cell area.

The first ion implantation connection region 126a of second conductivity type may connect the second-first well 124a of second conductivity type of first cell area and the second-second well 124b of second conductivity type of the third cell area to the first well 121 of second conductivity type disposed on the first ion implantation connection region 126a of second conductivity type.

The ion implantation connection region of second conductivity type may include a second ion implantation connection region 126b of second conductivity type that connects the second-second well 124b of second conductivity type disposed at the bottom of the trench area of second cell area and the second-first well 124a of second conductivity type disposed at bottom of the trench area of an adjacent fourth cell area in the negative (-) direction of the X-axis of second cell area.

The second ion implantation connection region 126b of second conductivity type may connect the second-second well 124b of second conductivity type of second cell area and the second-first well 124a of second conductivity type of the fourth cell area to the first well 121 of second conductivity type disposed on the second ion implantation connection region 126b of second conductivity type.

Additionally, a power converter according to an embodiment may include any one of the above power semiconductor devices.

According to the power semiconductor device, the power converter including the same, and the manufacturing method of the power semiconductor device according to the embodiment, there is a technical effect that it can solve the problem of increasing on-resistance (Rₒₙ) while preventing electric field concentration at the trench corner or the problem that adversely affect the electrical characteristics of the power semiconductor device.

For example, according to an embodiment, since the second well 124 of second conductivity type is disposed on the bottom side of the trench, and is disposed in a continuous form along the trench area, there is a technical effect of dispersing the electric field concentrated at the corner of the trench, preventing the breakdown voltage drop of the gate insulating layer, and improving the reliability of the gate insulating layer.

Additionally, according to the embodiment, the ion implantation connection region 126 of second conductivity type may connect the second well 124 of second conductivity type and the first well 121 of second conductivity type. Accordingly, the first well 121 of second conductivity type to which the ground potential is applied is connected to the second well 124 of second conductivity type by the ion implantation connection region 126 of second conductivity type, allowing the second well 124 of second conductivity type to also be at ground potential.

In addition, according to the embodiment, since the second well 124 of second conductivity type does not directly contact the bottom of the gate trench, there is an advantage in terms of thickness and characteristics that there is a reduced risk of forming an unexpectedly grown oxide layer during the thermal oxidation process for forming the gate insulating layer.

In addition, according to the embodiment, by applying a ground potential to the second conductivity type second well 124 that prevents electric field concentration at the trench corners, it is possible to prevent the formation of depletion regions in the second conductivity type second well 124, thereby preventing an increase in On-resistance (Rₒₙ).

In addition, according to the second embodiment, the first ion implantation connection region 126a of second conductivity type or the second ion implantation connection region 126b of second conductivity type is formed on one side or the other side of the gate insulating layer 131 of each cell, thereby enhancing the current flow by connecting the second well 124 of second conductivity type and the second well 124 of second conductivity type.

In addition, according to the third embodiment, the second-first well 124a of second conductivity type and the second-second well 124b of second conductivity type are spaced apart from each other on the bottom side of the corners on both sides of the trench, thereby improving current flow.

Additionally, according to the fourth embodiment, the first ion implantation connection region 126a of second conductivity type or the second ion implantation connection region 126b of second conductivity type is formed on one side or the other side of the gate insulating layer 131 of each cell, thereby enhancing the current flow.

In addition, according to the fourth embodiment, the second-first well 124a of second conductivity type and the second-second well 124b of second conductivity type are spaced apart from each other on the bottom side of the corners on both sides of the trench, thereby improving current flow.

The technical effects of the embodiments are not limited to those described in this item and include those that can be understood through the description of the invention.

### BRIEF DESCRIPTION OF THE DRAWINGS

FIG. 1 is an exemplary configuration diagram of a power converter 1000 according to an embodiment.
FIG. 2 is a cross-sectional view of a power semiconductor device 100 according to an embodiment.
FIG. 3 is a three-dimensional cross-sectional view of the power semiconductor device 101 according to the first embodiment.
FIGS. 4A and 4B are cross-sectional views taken along lines A-A' and B-B', respectively, of the power semiconductor device 101 shown in FIG. 3.
FIG. 5 is a three-dimensional cross-sectional view of the power semiconductor device 102 according to the second embodiment.
FIGS. 6A to 6C are cross-sectional views along lines A-A', B-B', and C-C' of the power semiconductor device 102 shown in FIG. 5, respectively.
FIG. 7 is a three-dimensional cross-sectional view of the power semiconductor device 103 according to the third embodiment.
FIGS. 8A and 8B are cross-sectional views along lines A-A' and B-B', respectively, of the power semiconductor device 103 shown in FIG. 7.
FIGS. 9A and 9B are cross-sectional views of a power semiconductor device 104 according to a fourth embodiment, respectively.

### DETAILED DESCRIPTION

Hereinafter, embodiments are described in detail with reference to the drawings.

The suffixes "module" and "unit" for the elements used in the following description are simply given in consideration of ease of writing this specification, and do not themselves give a particularly important meaning or role. Accordingly, the "module" and "unit" can be used interchangeably.

Terms including ordinal numbers, such as first and second, can be used to describe various elements, but the elements are not limited by the terms. These terms are only used for the purpose of distinguishing one element from another.

Singular expressions include plural expressions unless the context clearly dictates otherwise.

In this application, terms such as "comprise", "have" or "include" are intended to designate that there is a feature, number, step, operation, component, part, or combination thereof described in the specification, and it is not precluded from being excluded one or other features, numbers, steps, operations, components, parts, or combinations thereof, or any combination thereof.

### (Embodiment)

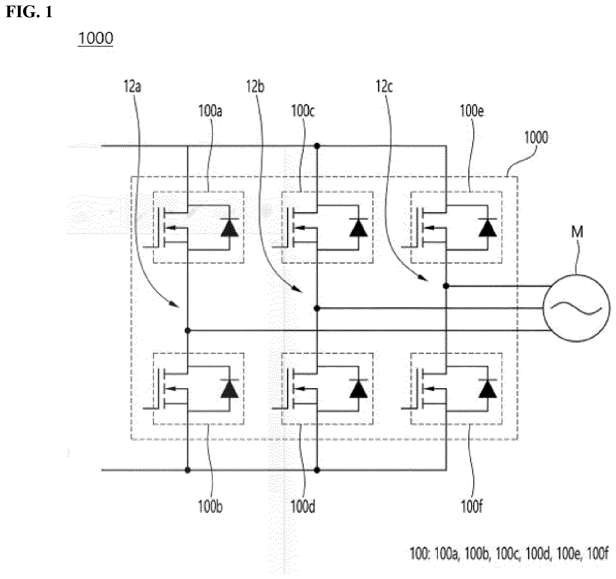

FIG. 1 is a circuit diagram of a power converter 1000 according to an embodiment.

The power converter 1000 according to the embodiment can receive DC power from a battery or fuel cell, convert it into AC power, and supply AC power to a predetermined load. For example, the power converter 1000 according to the embodiment can include an inverter, which receive DC power from a battery, convert DC power into 3-phase AC power, and supply 3-phase AC power to a motor M. And motor M can provide power to electric vehicles or fuel cell vehicles.

The power converter 1000 according to the embodiment can include the power semiconductor device 100. The power semiconductor device 100 can be a Metal Oxide Semiconductor Field Effect Transistor (MOSFET), but is not limited thereto, and can include an Insulated Gate Bipolar Transistor (IGBT).

For example, the power converter 1000 can include a plurality of power semiconductor devices 100a, 100b, 100c, 100d, 100e, and 100f, and can include a plurality of diodes (not shown). Each of the plurality of diodes can be internally incorporated in each of the power semiconductor devices 100a, 100b, 100c, 100d, 100e, and 100f in the form of an internal diode, but is not limited thereto, and can be disposed separately.

In the embodiment, DC power can be converted into AC power through on-off control of the plurality of power semiconductor devices 100a to 100f. For example, in the power converter 1000 according to the embodiment, the first power semiconductor device 100a can be turned on and the second power semiconductor device 100b can be turned off in a first time period of one cycle to supply positive polarity power to the motor M. In addition, in the second time period of one cycle, the first power semiconductor device 100a can be turned off and the second power semiconductor device 100b can be turned on to supply negative polarity power to the motor M.

In the embodiment, a group of power semiconductor devices disposed in series in a high voltage line and a low voltage line of an input side can be referred to as an arm. For example, the first power semiconductor device 100a and the second power semiconductor device 100b can constitute a first arm, and the third power semiconductor device 100c and the fourth power semiconductor device 100d can constitute a second arm. And the fifth power semiconductor device 100e and the sixth power semiconductor device 100f can constitute a third arm.

In the arm, an upper side power semiconductor device and a bottom side power semiconductor device can be controlled not to turn on at the same time. For example, in the first arm, the first power semiconductor device 100a and the second power semiconductor device 100b do not simultaneously turn on, but can turn on and off alternately.

Each of the power semiconductor devices 100a to 100f can receive high power in an off state. For example, when the second power semiconductor device 100b is turned off while the first power semiconductor device 100a is turned on, the input voltage can be applied to the second power semiconductor device 100b as it is. The voltage input to the second power semiconductor device 100b can be a relatively high voltage, and a withstand voltage of each power semiconductor device 100a to 100f can be designed to have a high level to withstand such a high voltage.

Each of the power semiconductor devices 100a to 100f can conduct a high current in a turn on state. The motor M can be driven with a relatively high current, and this high current can be supplied to the motor M through a power semiconductor that is turned on.

A high voltage applied to each of the power semiconductor devices 100a to 100f can cause a high switching loss. A high current conducting the power semiconductor devices 100a to 100f can cause a high conduction loss. In order to dissipate heat generated by such switching loss or conduction loss, the power semiconductor devices 100a to 100f can be packaged as a power semiconductor module including a heat dissipation means.

The power semiconductor device 100 of the embodiment can be a silicon carbide (SiC) power semiconductor device, can operate in a high-temperature, high-voltage environment, and can have a high switching speed and low switching loss.

Meanwhile, the power converter 1000 according to the embodiment can include a plurality of power semiconductor modules.

For example, the plurality of power semiconductor devices 100a to 100f shown in FIG. 1 can be packaged into one power semiconductor module, or the power semiconductor devices constituting each arm can be packaged into one power semiconductor module.

For example, the first power semiconductor device 100a, the second power semiconductor device 100b, the third power semiconductor device 100c, the fourth power semiconductor device 100d, and the fifth power semiconductor device 100e and the sixth power semiconductor device 100f shown in FIG. 1 can be packaged into one power semiconductor module.

In addition, there can be additional power semiconductor devices disposed in parallel with each of the power semiconductor devices 100a to 100f to increase a current capacity. In this case, the number of power semiconductor devices included in the power semiconductor module can be greater than six.

The power converter 1000 according to the embodiment can include a diode-type power semiconductor device in addition to the transistor-type power semiconductor devices 100a to 100f. For example, a first diode (not shown) can be disposed in parallel with the first power semiconductor device 100a, and a second diode (not shown) can be disposed in parallel with the second power semiconductor device 100b. Also, these diodes can be packaged together in one power semiconductor module. In addition, the diode can be disposed in the form of an internal diode in each power semiconductor device.

Next, the power semiconductor devices constituting each arm can be packaged into one power semiconductor module.

For example, the first power semiconductor device 100a and the second power semiconductor device 100b constituting the first arm can be packaged as a first power semiconductor module. The third power semiconductor device 100c and the fourth power semiconductor device 100d constituting the second arm can be packaged into a second power semiconductor module. And the fifth power semiconductor device 100e and the sixth power semiconductor device 100f constituting the third arm can be packaged into a third power semiconductor module.

In addition, there can be additional power semiconductor devices arranged in parallel with each power semiconductor device 100a to 100f to increase a current capacity. In this case, the number of power semiconductor devices included in each power semiconductor module can be more than two. Also, each arm can include a diode-type power semiconductor device (not shown) in addition to the transistor-type power semiconductor devices 100a to 100f, and these diodes can also be packaged together in one power semiconductor module. In addition, the diode can be disposed in a form of an internal diode in each power semiconductor device.

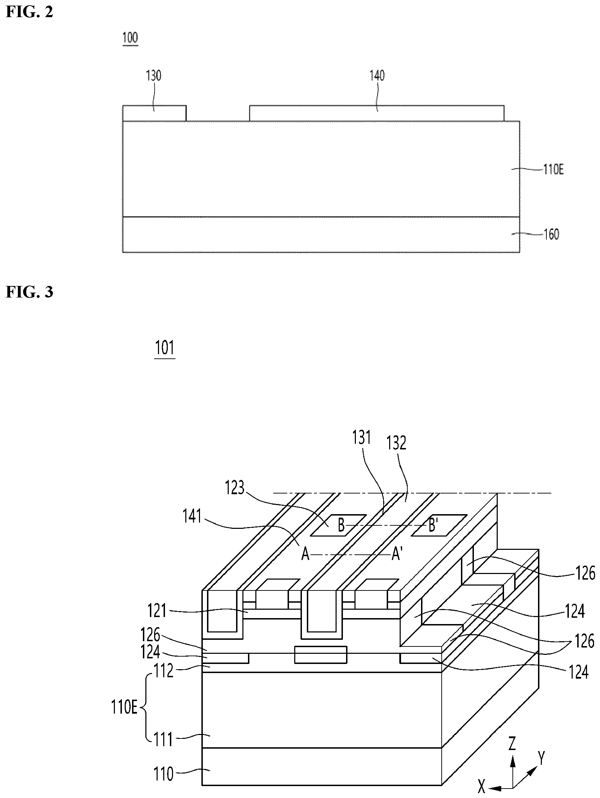

Next, FIG. 2 is a cross-sectional view of one of the power semiconductor devices 100 according to an embodiment.

The power semiconductor device 100 according to the embodiment may include a source electrode 140, a gate electrode 130 arranged to be spaced apart from each other on the upper side of a predetermined semiconductor epitaxial layer 110E, and a drain electrode 160 disposed below the semiconductor epitaxial layer 110E.

In the form of a MOSFET, the source electrode 140 or the gate electrode 130 may include an Al-based metal and may include a Ni layer, a Ti layer, a Ni/Ti layer, or a TiN/Ti silicide layer.

The drain electrode 160 may include a Ni-based metal and may include a Ti layer, a Ni layer, or an Ag layer. For example, the drain electrode 160 may include Ti/Ag, Ti/Ni/Ag, NiV/Ag, or V(vanadium)/Ni/Ag, etc., but is not limited thereto.

One of the technical objects of the embodiment is to solve the technical contradiction of preventing breakdown voltage drop and increasing on-resistance (Rₒₙ) due to preventing electric field concentration at the corner of the trench.

Hereinafter, technical features of a power semiconductor device according to an embodiment for solving the above technical problems will be described.

FIG. 3 is a three-dimensional cross-sectional view of the power semiconductor device 101 according to the first embodiment.

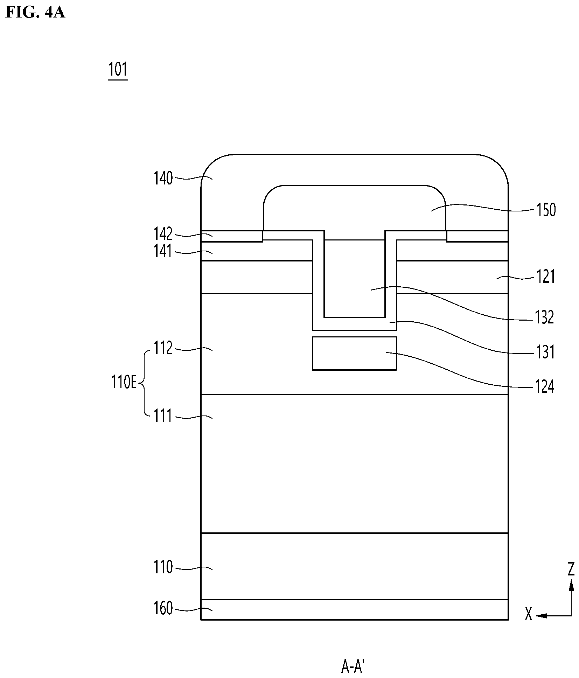

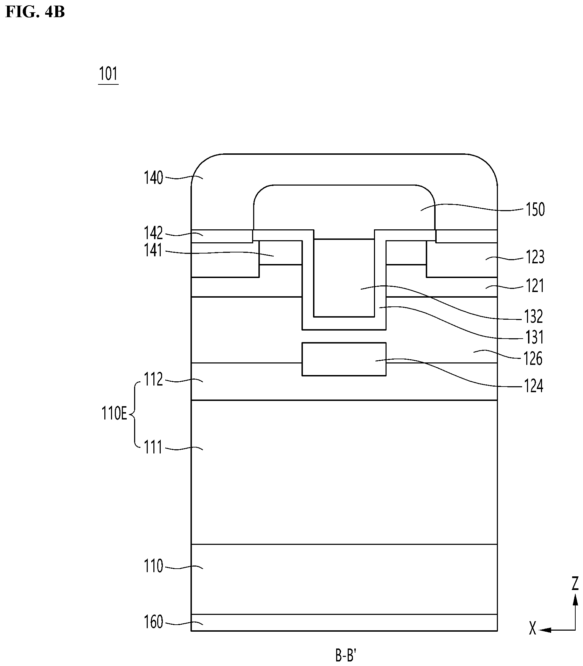

FIGS. 4A and 4B are cross-sectional views along lines A-A' and B-B', respectively, of the power semiconductor device 101 shown in FIG. 3. Hereinafter, `first embodiment' may be abbreviated and described as 'embodiment'.

Referring to FIGS. 3, 4A, and 4B, the power semiconductor device 101 according to the first embodiment may include a drain electrode 160 (see FIG. 4A), a substrate 110, an epi layer 110E, a first well 121 of second conductivity type, a first conductivity type source area 141, a source contact area 142 (see FIG. 4A), a second conductivity type contact area 123 (see FIG. 4B), a source electrode 140 (see FIG. 4A), a gate insulating layer 131, a trench gate 132, and an interlayer insulating layer 150 (see FIG. 4A).

The epi layer 110E may include a first epi layer 111 of first conductivity type and a second epi layer 112 of first conductivity type.

Additionally, the embodiment may include a first well 121 of second conductivity type, a second well 124 of second conductivity type, and an ion implantation connection region 126 of second conductivity type.

The first conductivity type may be N-type, and the second conductivity type may be P-type, but are not limited thereto. For example, the N-type dopant may be implanted with N or P, but is not limited thereto. Additionally, the P-type dopant may be implanted with Al or Boron, but is not limited thereto.

Specifically, referring to FIGS. 4A and 4B, the power semiconductor device 101 according to the embodiment may include a substrate 110 and a first epi layer 111 of first conductivity type disposed on the substrate 110 and a second epi layer 112 of first conductivity type disposed on the first epi layer 111 of first conductivity type.

The substrate 110, the first epitaxial layer 112 of first conductivity type, and the second epitaxial layer 112 of first conductivity type may include silicon carbide (SiC) and may be doped into N-type, but are not limited thereto. For example, the substrate 110 and the first and second epi layers 111 and 112 of first conductivity type may include a 4H-SiC material, but are not limited thereto. For example, the substrate 110 and the first and second epi layers 111 and 112 of first conductivity type may include 3C-SiC or 6H-SiC.

The first epi layer 111 of first conductivity type may include a first conductivity type buffer layer (not shown) and a first conductivity type drift layer (not shown). The first epi layer 111 of first conductivity type is doped at a lower concentration than the substrate 110, thereby preventing a breakdown voltage (VB) drop.

In addition, the second epitaxial layer 112 of first conductivity type is doped at a higher concentration than the first epitaxial layer 111 of first conductivity type, allowing the second epitaxial layer (112) of first conductivity type to function as a current spreading layer (CSL) and thereby reducing the on-resistance.

The first well 121 of second conductivity type may be formed by ion implantation of second conductivity type dopant into the second epi layer 112 of first conductivity type or by growing the second conductivity type epi layer. The first well 121 of second conductivity type may be referred to as a second conductivity type base layer, but is not limited thereto.

Referring to FIG. 4B, the first conductivity type source area 141 and the second conductivity type contact area 123 may be formed by ion implantation into the first well 121 of second conductivity type.

The doping concentration of first conductivity type source area 141 and the second conductivity type contact area 123 may be higher than that of first well 121 of second conductivity type. The second conductive contact area 123 may be partially formed as shown in FIG. 3. The second conductivity type contact area 123 may function to maintain the zero potential of first well 121 of second conductivity type.

Next, the gate insulating layer 131 can be formed by thermal oxidation or deposition process on a bottom and sidewall of the trench area where the first conductivity type source area 141, the first well 121 of second conductivity type and the second epi layer 112 of first conductivity type has been removed.

Next, a trench gate 132 may be formed on the trench above the gate insulating layer 131 through a process involving polysilicon deposition and etch-back.

Next, a source contact area 142 may be formed of first conductive type source area 141 and/or the second conductive type contact area 123. For example, the source contact area 142 may be formed using Ti or Ni, but is not limited thereto.

Next, the interlayer insulating layer 150 may be formed on the trench gate 132 through a deposition process such as an oxide film.

Next, a source electrode 140, a gate electrode (not shown), and a drain electrode 160 may be formed.

For example, the source electrode 140 or the gate electrode 130 may include an Al-based metal and may include a Ni layer, a Ti layer, a Ni/Ti layer, or a TiN/Ti silicide layer. Additionally, the drain electrode 160 may include a Ni-based metal and may include a Ti layer, a Ni layer, and an Ag layer. For example, the drain electrode 160 may include Ti/Ag, Ti/Ni/Ag, or NiV/Ag, V(vanadium)/Ni/Ag, etc., but is not limited thereto.

Next, referring to FIG. 4B, the embodiment may include a second well 124 of second conductivity type disposed on the second epi layer 112 of first conductivity type and spaced apart from the gate insulating layer 131 and the first well 121 of second conductivity type. Also, the embodiment may include an ion implantation connection region 126 of second conductivity type connecting the first well 121 of second conductivity type and the second well 124 of second conductivity type.

The second well 124 of second conductivity type is disposed below the trench, and may be doped at a concentration lower than that of second well 124 of second conductivity type, but is not limited thereto.

The ion implantation connection region 126 of second conductivity type may be doped at a concentration lower than that of second well 124 of second conductivity type, but is not limited thereto.

Referring to FIG. 3, the second well 124 of second conductivity type is disposed below the trench and may be disposed in a continuous form along the trench area.

The second well 124 of second conductivity type can be formed by high-energy ion implantation or by using a re-growth process. For example, after growing the second epi layer 112 of first conductivity type on the first epi layer 111 of first conductivity type, the second well 124 of second conductivity type may be formed through high-energy ion implantation. Alternatively, after forming the first epi layer 111 of first conductivity type, the second well 124 of second conductivity type may be formed by ion implantation, and then the second epi layer 112 of first conductivity type may be formed.

The second well 124 of second conductivity type may be arranged to extend horizontally in the first direction Y, which is which is the extension direction of the trench gate 132.

On the other hand, the ion implantation connection region 126 of second conductivity type may be arranged to extend in the second direction X perpendicular to the first direction Y, which is the extension direction of the trench gate 132.

The ion implantation connection region 126 of second conductivity type can be arranged to extend vertically in the second direction X while connecting the horizontally arranged the second well 124 of second conductivity type in the first direction Y, which is offset in the first direction Y.

The top of second conductivity type ion implantation connection region 126 may be disposed higher than the bottom of the gate insulating layer 131, and the bottom of second conductivity type ion implantation connection region 126 may be disposed lower than the bottom of the gate insulation layer 131.

According to the power semiconductor device, the power converter including the same, and the manufacturing method of the power semiconductor device according to the embodiment, there are technical effects that can be solve the problem of increasing on-resistance (Rₒₙ) while preventing electric field concentration at the corner of the trench or affecting negative impact to characteristics of the power semiconductor device.

For example, according to an embodiment, the second well 124 of second conductivity type is disposed on the bottom side of the trench, and is disposed in a continuous form along the trench area, there is a technical effect of dispersing the electric field concentrated at the corner of the trench, preventing the breakdown voltage drop of the gate insulating layer, and improving the reliability of the gate insulating layer.

Additionally, according to the embodiment, the ion implantation connection region 126 of second conductivity type may connect the second well 124 of second conductivity type and the first well 121 of second conductivity type. Accordingly, the first well 121 of second conductivity type to which the ground potential is applied is connected to the second well 124 of second conductivity type by the ion implantation connection region 126 of second conductivity type, allowing the second well 124 of second conductivity type to also be at ground potential.

In addition, according to the embodiment, since the second well 124 of second conductivity type does not directly contact the bottom of the gate trench, there is an advantage in terms of thickness and characteristics that there is a reduced risk of forming an unexpectedly grown oxide layer during the thermal oxidation process for forming the gate insulating layer.

Meanwhile, in internal technology, research was conducted to place a bottom P-well under the trench to prevent electric field concentration at the corner of the trench.

First, using the first internal technology, a 'floating bottom P-well' was formed in a floating state spaced apart from the trench gate and gate insulating layer.

This 'floating bottom P-well' has the effect of preventing a breakdown voltage drop by relieving the electric field concentration at the corner of the trench, but a problem was studied in which charging and discharging continuously occur repeatedly inside the floating bottom P-well, thereby affecting the potential around the floating bottom P-well.

In other words, the problem of adversely affecting the electrical characteristics of power semiconductor devices was studied by generating an unknown internal potential in the floating bottom P-well in addition to the applied external potential.

Additionally, the floating bottom P-well interferes with current flow in the on state, causing an increase in ON-resistance (Rₒₙ/R_{DS}), which is the resistance between drain and source.

Next, using the second internal technology, a 'contacted bottom P-well' was formed on the bottom side of the trench to contact the trench gate insulating layer.

However, when a 'contacted bottom P-well' is formed at the bottom of the trench to be in contact with the trench gate insulating layer, there is an effect of alleviating electric field concentration at the trench corner, but the problem of deterioration of forward current characteristics due to an increase in the width of the depletion layer in the 'contacted bottom P-well' in contact with the gate insulating layer according to the drain voltage was studied.

Additionally, when the 'contacted bottom P-well' is formed close to the P-base (P-well) to be in contact with the trench gate insulating layer, the problem of increasing ON-resistance (Rₒₙ) due to JFET resistance occurring between the P-base (P-well) and the bottom P-well in contact was studied.

On the other hand, referring to FIGS. 3 and 4B, in the embodiment, the ion implantation connection region 126 of second conductivity type may connect the second well 124 of second conductivity type and the first well 121 of second conductivity type. Accordingly, the first well 121 of second conductivity type to which the ground potential is applied is connected to the second well 124 of second conductivity type by the ion implantation connection region 126 of second conductivity type, allowing the second well 124 of second conductivity type to also be at ground potential.

Therefore, according to the embodiment, by applying a ground potential to the second well 124 of second conductivity type that prevents electric field concentration at the trench corners, it is possible to prevent the formation of depletion regions in the second conductivity type second well 124, thereby preventing an increase in On-resistance (Rₒₙ).

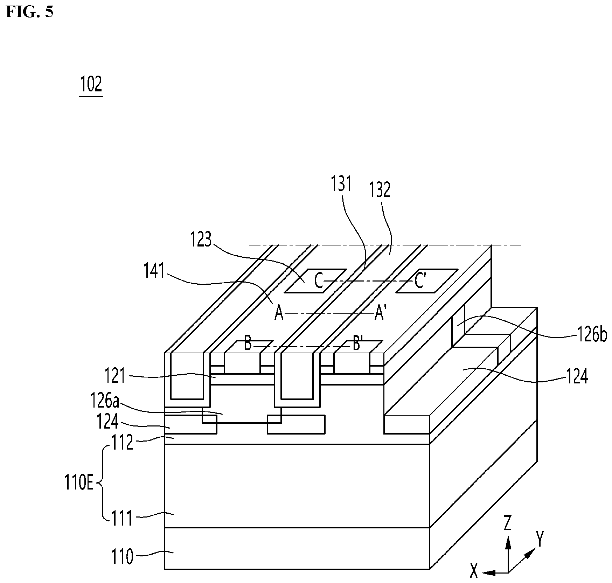

Next, Fig. 5 is a three-dimensional cross-sectional view of the power semiconductor device 102 according to the second embodiment.

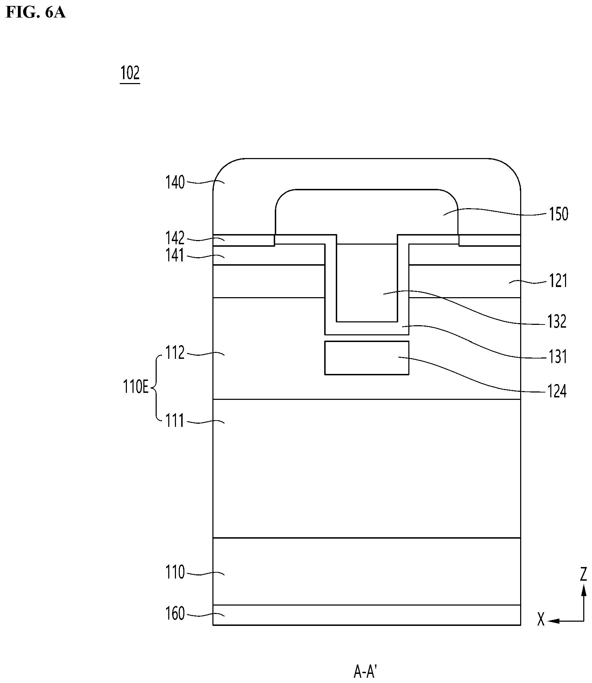

FIGS. 6A to 6C are cross-sectional views along lines A-A', B-B', and C-C' of the power semiconductor device 102 shown in FIG. 5, respectively.

The second embodiment can adopt the technical features of first embodiment described above, and the description will now focus on the features of second embodiment.

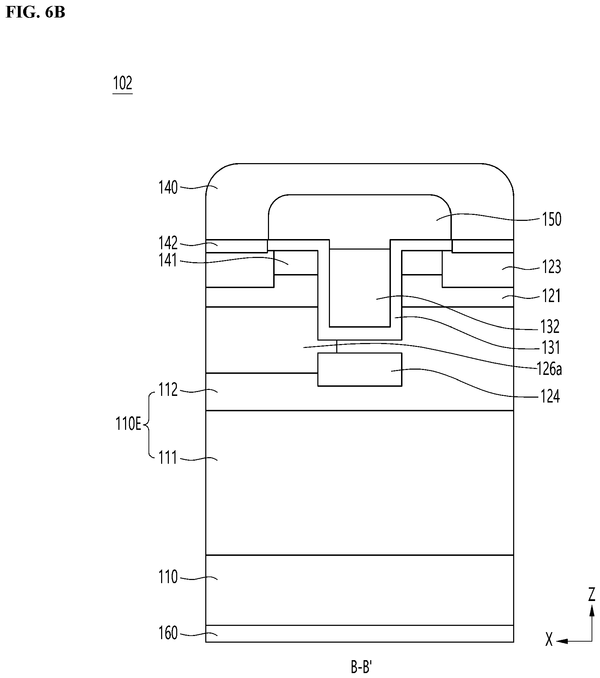

FIGS. 5 and 6A to 6C, the power semiconductor device 102 according to the second embodiment may include one or more of a drain electrode 160 (see FIG. 6A), a substrate 110, an epi layer 110E, a first well 121 of second conductivity type, a source area 141 of first conductivity type, a source contact area 142 (see FIG. 6A), and a contact area 123 of second conductivity type (see FIG. 6B), a source electrode 140 (see FIG. 6A), a gate insulating layer 131, a trench gate 132, and an interlayer insulating layer 150 (see FIG. 6a).

The epi layer 110E may include a first epi layer 111 of first conductivity type and a second epi layer 112 of first conductivity type.

The second embodiment may include a first well 121 of second conductivity type and a second well 124 of second conductivity type.

At this time, unlike the first embodiment, the second embodiment may include a first ion implantation connection region 126a of second conductivity type and a second ion implantation connection region 126b of second conductivity type.

For example, the first embodiment is a structure that the ion implantation connection region 126 of second conductivity type has a stripe structure that continuously connects the second wells 124 of second conductivity type of adjacent cells.

On the other hand, the second embodiment includes a structure that the first ion implantation connection region 126a of second conductivity type or the second ion implantation connection region 126b of second conductivity type intersects on a cell basis to connect the second well 124 of second conductivity type.

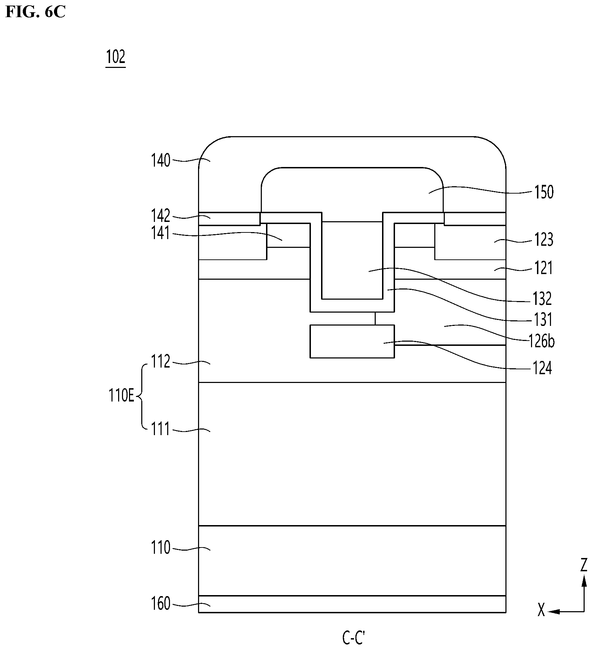

For example, FIGS. 6B and 6C are cross-sectional views along lines B-B' and C-C' of the power semiconductor device 102 shown in FIG. 5, respectively, and FIGS. 6B and 6C are cross-sectional views of first cell area and the second cell area of second power semiconductor device 102.

For example, referring to FIG. 6B, in the first cell area, the first ion implantation connection region 126a of second conductivity type may be disposed on one side of the gate insulting layer 131 to connect the second well 124 of second conductivity type to the second well 124 of second conductivity type. For example, the first ion implantation connection region 126a may be disposed on the left side of the gate insulating layer.

Referring to FIGS. 5 and 6B together, the first ion implantation connection region 126a of second conductivity type may be disposed between the trench area in the first cell area and the trench area in an adjacent third cell area in the positive (+) direction of the X-axis of first cell area.

At this time, the first ion implantation connection region 126a of second conductivity type may connects the second well 124 of second conductivity type disposed below the trench area in the first cell area and the second well 124 of second conductivity type disposed below the trench area in the third cell area adjacent to the first cell area in the X-axis direction.

In addition, the first ion implantation connection region 126a of second conductivity type may connect the second well 124 of second conductivity type in the first cell area and the second well 124 of second conductivity type in the third cell area to the first well 121 of second conductivity type disposed on the upper side of first ion implantation connection region 126a of second conductivity type.

Also, referring to FIG. 6C, in the second cell area, the second ion implantation connection region 126b of second conductivity type may be disposed on the other side of the gate insulting layer 131 to connect the second well 124 of second conductivity type to the second well 124 of second conductivity type. For example, the first ion implantation connection region 126a may be disposed on the right side of the gate insulating layer.

Referring to FIGS. 5 and 6C together, the second ion implantation connection region 126b of second conductivity type may be disposed between the trench area in the second cell area and the trench area in an adjacent fourth cell area in the negative (-) direction of the X-axis of second cell area.

At this time, the second ion implantation connection region 126b of second conductivity type may connects the second well 124 of second conductivity type disposed below the trench area in the second cell area and the second well 124 of second conductivity type disposed below the trench area in the fourth cell area adjacent to the negative (-) direction of the X-axis of second cell area.

In addition, the second ion implantation connection region 126b of second conductivity type may connect the second well 124 of second conductivity type in the second cell area and the second well 124 of second conductivity type in the fourth cell area to the first well 121 of second conductivity type disposed on the upper side of first ion implantation connection region 126a of second conductivity type.

According to the second embodiment, the second well 124 of second conductivity type is disposed on the bottom side of the trench, is disposed in a continuous form along the trench area, there is a technical effect of dispersing the electric field concentrated at the corner of the trench, preventing the breakdown voltage drop of the gate insulating layer, and improving the reliability of the gate insulating layer.

In addition, according to the second embodiment, the first ion implantation connection region 126a of second conductivity type or the second ion implantation connection region 126b of second conductivity type may connect the second well 124 of second conductivity type and the first well 121 of second conductivity type. Accordingly, the first well 121 of second conductivity type to which the ground potential is applied can be connected to the second well 124 of second conductivity type by the first ion implantation connection region 126a of second conductivity type or the second ion implantation connection region 126b of second conductivity type, allowing the second well 124 of second conductivity type to also be at ground potential.

Accordingly, according to the second embodiment, the ground potential is applied to the second well 124 of second conductivity type, which prevents electric field concentration at the trench corner, thereby preventing the generation of a depletion area in the second well 124 of second conductivity type. There is a complex technical effect that can prevent an increase in On-resistance (Rₒₙ).

In addition, according to the second embodiment, the first ion implantation connection region 126a of second conductivity type or the second ion implantation connection region 126b of second conductivity type is formed on one side or the other side of the gate insulating layer 131 of each cell, thereby enhancing the current flow by connecting the second well 124 of second conductivity type and the second well 124 of second conductivity type

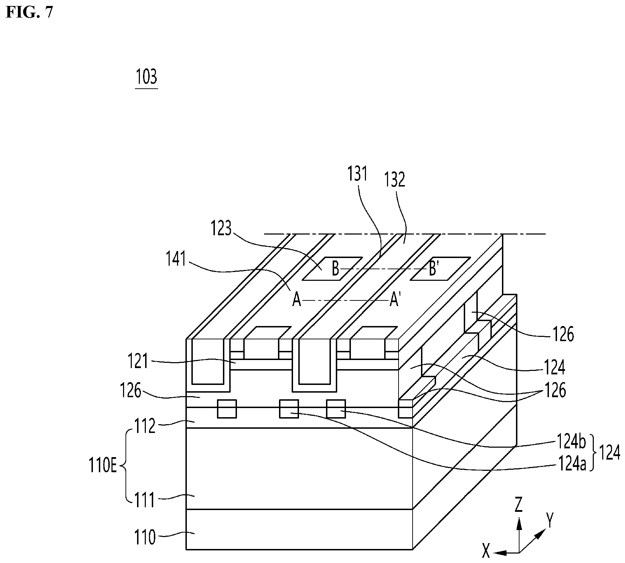

Next, FIG. 7 is a three-dimensional cross-sectional view of the power semiconductor device 103 according to the third embodiment.

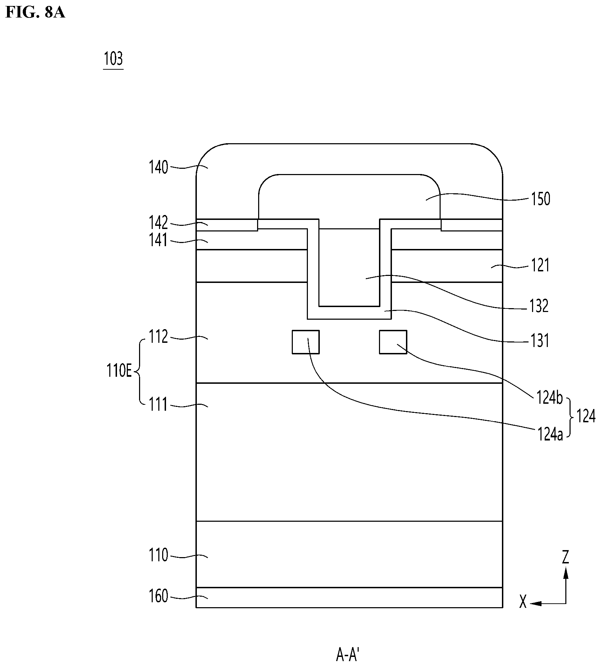

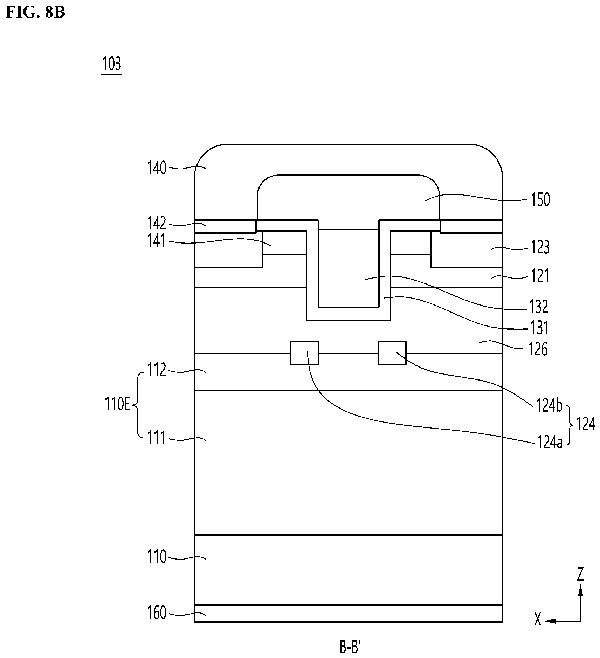

FIGS. 8A and 8B are cross-sectional views along lines A-A' and B-B', respectively, of the power semiconductor device 103 shown in FIG. 7.

The third embodiment may adopt the technical features of first or second embodiment described above, and the description will focus on the features of the third embodiment below.

Referring to FIGS. 7, 8A, and 8B, unlike the first embodiment, the second well 124 of second conductivity type of the third embodiment may include a second-first well 124a of second conductivity type and a second-second well 124b of second conductivity type disposed at the corners of both sides of the trench respectively.

For example, the second well 124 of second conductivity type in the first embodiment may be disposed on the bottom side of the trench to correspond to the width of the trench.

On the other hand, the second well 124 of second conductivity type of the third embodiment may include the second-first well 124a of second conductivity type and the second-second well 124b of second conductivity type disposed at the lower corners of both sides of the trench in the extending direction of the trench gate 132.

According to the third embodiment, the second well 124 of second conductivity type is disposed on the bottom side of the trench corner, dispersing the electric field concentrated at the trench corner, preventing the breakdown voltage drop of the gate insulating layer, and improving the reliability of the gate insulating layer

Additionally, according to the third embodiment, the ion implantation connection region 126 of second conductivity type may connect the second well 124 of second conductivity type and the first well 121 of second conductivity type. Accordingly, the first well 121 of second conductivity type to which the ground potential is applied is connected to the second well 124 of second conductivity type by the ion implantation connection region 126 of second conductivity type. As a result, the ground potential can also be applied to the second well 124 of second conductivity type.

Accordingly, according to the third embodiment, the ground potential is applied to the second well 124 of second conductivity type, which prevents the electric field concentration at the trench corner, thereby preventing the generation of a depletion area in the second well 124 of second conductivity type. Also, there is a complex technical effect that can prevent an increase in On-resistance (Rₒₙ).

In addition, according to the third embodiment, the second-first well 124a of second conductivity type and the second-second well 124b of second conductivity type are disposed at the bottom side of the corners on both sides of the trench and are spaced apart from each other, thereby there are complex technical effects that current flow can be improved.

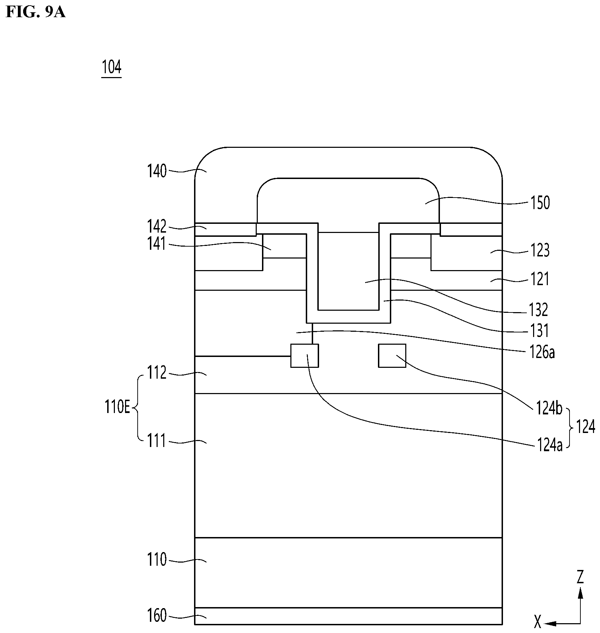

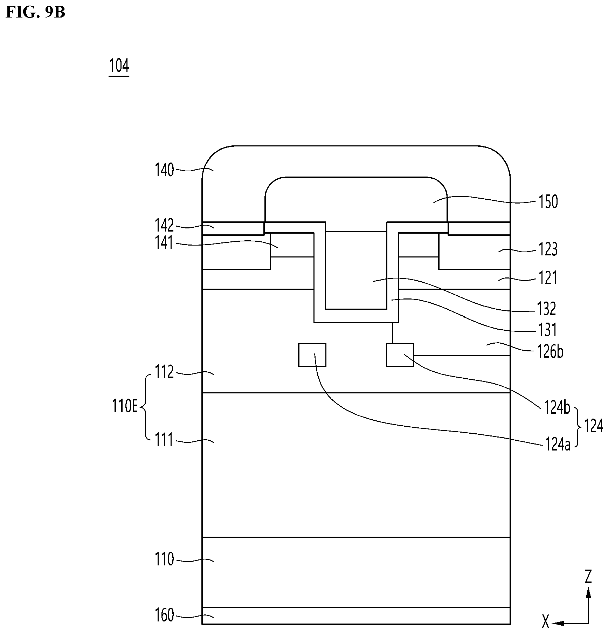

Next, FIGS. 9A and 9B are cross-sectional views of the power semiconductor device 104 according to the fourth embodiment, respectively.

The fourth embodiment can adopt the technical features of the third embodiment described above, and the description will now focus on the features of the fourth embodiment.

Unlike the third embodiment, the fourth embodiment may include a first ion implantation connection region 126a of second conductivity type and a second ion implantation connection region 126b of second conductivity type.

For example, in the third embodiment has a structure (see Fig. 7) where the ion implantation connection region 126 of second conductivity type continuously connects the second wells 124 of second conductivity type of adjacent cells in a stripe structure.

On the other hand, in the fourth embodiment has a structure where the first ion implantation connection region 126a of second conductivity type or the second ion implantation connection region 126b of second conductivity type intersects on a cell basis.

For example, FIGS. 9A and 9B may be cross-sectional views of first cell area and the second cell area of the fourth power semiconductor device 104.

For example, referring to FIG. 9A, in the first cell area, the first ion implantation connection region 126a of second conductivity type is disposed on one side, for example, the left side of the gate insulating layer 131, and may connect the second-first well 124a of second conductivity type to the second-second well 124b of second conductivity type.

For example, the first ion implantation connection region 126a of second conductivity type may be disposed between the trench area of first cell area and the trench area of the third cell area adjacent to the positive (+) direction of the X-axis of first cell area.

At this time, the first ion implantation connection region 126a of second conductivity type may connect the second-first well 124a of second conductivity type disposed below the trench area of first cell area to the second-second well 124b of second conductivity type disposed below the trench area of the third cell area adjacent to the first cell area in the X-axis direction.

In addition, the first ion implantation connection region 126a of second conductivity type may connect the second-first well 124a of second conductivity type of first cell area and the second-second well 124b of second conductivity type of the third cell area to the first well 121 of second conductivity type disposed on the upper side of first ion implantation connection region 126a of second conductivity type.

Also, referring to FIG. 9B, in the second cell area, the second ion implantation connection region 126b of second conductivity type is disposed on the other side, for example, the right side, of the gate insulating layer 131 and may connect the second-second well 124b of second conductivity type to the second-first well 124a of second conductivity type.

For example, the second ion implantation connection region 126b of second conductivity type may be disposed between the trench area of second cell area and the trench area of the fourth cell area adjacent to the negative (-) direction of the X-axis.

At this time, the second ion implantation connection region 126b of second conductivity type may connect the second-second well 124b of second conductivity type disposed below the trench area of second cell and the second-first well 124a of second conductivity type disposed below the trench area of the fourth cell area adjacent to the negative (-) direction of the X-axis of second cell area.

In addition, the second ion implantation connection region 126b of second conductivity type may connect the second-second well 124b of second conductivity type of second cell and the second-first well 124a of second conductivity type to the first well 121 of second conductivity type disposed on the upper side of second ion implantation connection region 126b of second conductivity type.

According to the fourth embodiment, the second well 124 of second conductivity type is disposed on the bottom side of the trench and is disposed in a continuous form along the trench area, there is a technical effect of dispersing the electric field concentrated at the corner of the trench, preventing the breakdown voltage drop of the gate insulating layer, and improving the reliability of the gate insulating layer.

In addition, according to the fourth embodiment, by applying a ground potential to the second-first well 124a of second conductivity type and the second-second well 124b of second conductivity type that prevents electric field concentration at the trench corners, it is possible to prevent the formation of depletion regions in the second conductivity type second well 124, thereby preventing an increase in On-resistance (Rₒₙ).

Additionally, according to the fourth embodiment, the first ion implantation connection region 126a of second conductivity type or the second ion implantation connection region 126b of second conductivity type is formed on one side or the other side of the gate insulating layer 131 of each cell, thereby enhancing the current flow.

In addition, according to the fourth embodiment, the second-first well 124a of second conductivity type and the second-second well 124b of second conductivity type are spaced apart from each other on the bottom side of the corners on both sides of the trench, thereby improving current flow.

Although the present invention has been described above with reference to embodiments, those skilled in the art can modify the present invention in various ways without departing from the scope of the present invention as set forth in the claims below. It will be easy to understand that and can be changed.

## Claims

1. A power semiconductor device comprising:
a substrate;
a first epi layer of first conductivity type disposed on the substrate;
a second epi layer of first conductivity type disposed on the first epi layer of first conductivity type;
a first well of second conductivity type disposed on the second epi layer of first conductivity type;
a first conductivity type source area disposed on the second conductivity type first well;
a gate insulating layer disposed on a bottom and sidewalls of the trench area from which a portion of first conductive type source area, the first well of second conductive type, and the second epi layer of first conductive type are removed;
a trench gate disposed in the trench on the gate insulating layer;
a second well of second conductivity type disposed on the second epi layer of first conductivity type and spaced apart from the gate insulating layer; and
an ion implantation connection region of second conductivity type connecting the first well of second conductivity type and the second well of second conductivity type.

2. The power semiconductor device according to claim 1, wherein when a ground potential is applied to the first well of second conductivity type, a ground potential is also applied to the second well of second conductivity type by the ion implantation connection region of second conductivity type.

3. The power semiconductor device according to any one of claims 1 or 2, wherein the second well of second conductivity type is disposed below the trench and/or is disposed in a continuous form along the trench area.

4. The power semiconductor device according to claim 1, 2 or 3, wherein the second well of second conductivity type is arranged to extend in a first direction Y horizontally to the first direction Y, which is an extension direction of the trench gate.

5. The power semiconductor device according to claim 4, wherein the ion implantation connection region of second conductivity type is arranged to extend in a second direction X perpendicular to the first direction Y, which is an extension direction of the trench gate.

6. The power semiconductor device according to claim 4 or 5, wherein the ion implantation connection region of second conductivity type is configured to connect the second well of second conductivity type arranged horizontally in the first direction Y while being spaced apart in the first direction Y and is arranged to extend in a second direction X perpendicular to the first direction Y.

7. The power semiconductor device according to any one of claims 1 to 6, wherein a top of the ion implantation connection region of second conductivity type is disposed higher than a bottom of the gate insulating layer, and
wherein the bottom of the ion implantation connection region of second conductivity type is disposed lower than the bottom of the gate insulating layer.

8. The power semiconductor device according to any one of claims 1 to 7, wherein the ion implantation connection region of second conductivity type continuously is configured to connect the second wells of second conductivity type of three or more adjacent cells.

9. The power semiconductor device according to any one of claims 1 to 8, wherein the ion implantation connection region of second conductivity type is configured to connect the second well of second conductivity type by crossing on a single cell basis.

10. The power semiconductor device according to claim 9, wherein the ion implantation connection region of second conductivity type comprises a first ion implantation connection region of second conductivity type connecting the second well of second conductivity type disposed below the trench area of first cell and a second well of second conductivity type disposed below the trench area of the third cell area adjacent to the X-axis direction of first cell area.

11. The power semiconductor device according to any one of claims 1 to 10, wherein the second well of second conductivity type comprises a second-first well of second conductivity type and a second-second well of second conductivity type disposed at corners on both sides of the trench, respectively.

12. The power semiconductor device according to claim 11, wherein the second-first well of second conductivity type and the second-second well of second conductivity type are respectively disposed on the bottom side of the corners on both sides of the trench in the extending direction of the trench gate.

13. The power semiconductor device according to claim 11 or 12, wherein the ion implantation connection region of second conductivity type is configured to connect the second well of second conductivity type by crossing on the basis of one cell.

14. The power semiconductor device according to claim 13, wherein the ion implantation connection region of second conductivity type comprises a first ion implantation connection region of second conductivity type connecting the second-first well of second conductivity type disposed below the trench area of first cell area and the second-second well of second conductivity type disposed below the trench area of the third cell area adjacent to the positive direction of the X-axis of first cell area.

15. A power converter comprising the power semiconductor device according to any one of claims 1 to 14.
